(19) Europäisches Patentamt
European Patent Office
Office européen des brevets

(11) EP 2 602 289 A2

(12) # EUROPEAN PATENT APPLICATION

(43) Date of publication:
**12.06.2013 Bulletin 2013/24**

(21) Application number: **12184491.4**

(22) Date of filing: **14.09.2012**

(51) Int Cl.:
***C08L 63/00*** *(2006.01)*
***H01L 23/29*** *(2006.01)*
***C08K 3/00*** *(2006.01)*
***C08K 3/36*** *(2006.01)*
***C08G 59/62*** *(2006.01)*
***C08L 61/04*** *(2006.01)*
***C08L 83/04*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **07.12.2011 JP 2011268039**

(71) Applicant: **NITTO DENKO CORPORATION**
**Osaka 567 (JP)**

(72) Inventors:
- **Kitagawa, Yuya**
  **Ibaraki-shi, Osaka 567-8680 (JP)**
- **Fusumada, Mitsuaki**
  **Ibaraki-shi, Osaka 567-8680 (JP)**
- **Mizushima, Aya**
  **Ibaraki-shi, Osaka 567-8680 (JP)**
- **Nakamura, Koki**
  **Ibaraki-shi, Osaka 567-8680 (JP)**
- **Ono, Yuta**
  **Ibaraki-shi, Osaka 567-8680 (JP)**

(74) Representative: **Grünecker, Kinkeldey,**
**Stockmair & Schwanhäusser**
**Leopoldstrasse 4**
**80802 München (DE)**

(54) **Epoxy resin composition for electronic parts encapsulation and electronic parts-equipped device using the same**

(57) The present invention relates to an epoxy resin composition for electronic parts encapsulation, including the following components (A) to (E), (A) an epoxy resin having an ICI viscosity of from 0.008 to 0.1 Pa·s and an epoxy equivalent of from 100 to 200 g/eq; (B) a phenol resin having an ICI viscosity of from 0.008 to 0.1 Pa·s and a hydroxyl-group equivalent of from 100 to 200 g/eq; (C) a curing accelerator; (D) an inorganic filler; and (E) a silicone compound, in which the component (D) is contained in an amount of from 82 to 88 wt% of the whole of the epoxy resin composition, the component (E) is contained in an amount of from 5 to 15 wt% of the whole of organic components in the epoxy resin composition, and the epoxy resin composition has a gelation time of 15 to 25 seconds.

EP 2 602 289 A2

## Description

### FIELD OF THE INVENTION

The present invention relates to an epoxy resin composition for electronic parts encapsulation which ensures excellent low-shrink properties, and relates to an electronic parts-equipped device using the epoxy resin composition.

### BACKGROUND OF THE INVENTION

As packaging forms of power modules into which power devices, such as insulated-gate bipolar transistors (IGBT) or metal oxide semiconductor field effect transistors (MOSFET), are integrated with drive circuits and self-protecting functions, case-type packages using silicone gel have been mainstream until now. Such case-type packages have been capable of production under a small investment by the use of a simple and easy encapsulation method, and have had high reliability and track records in many markets.

However, the case-type packages have had problems of being large in numbers of constituent substances, large in package sizes, poor in productivity and relatively high in production costs. And plastic packaging through resin encapsulation has therefore received attention recently in the field of power modules also. For the resin encapsulation for plastic packaging, epoxy resin compositions have been used from the viewpoint of their excellence in productivity and reliability of products, and they have clocked up good track records in the field of packages for discrete semiconductors.

In addition, power devices are very exothermic because they use large currents, and packages of power modules themselves are therefore required to have the property of dissipating heat to a high degree. Although the previously dominating structure of the packages was a structure of having a heat spreader on one side of each package, semiconductor devices of double-cooled structure having a heat spreader on both sides of each device's package have been developed in recent years through the need for further improvement in heat dissipation capability (see Patent Document 1). Each of the semiconductor devices of such double-cooled structure has a characteristic that its package resists warpage because of having heat spreaders on both sides, whereby it is resistant to releasing stresses caused by differences in linear expansion coefficients among its members. There arises, as a result, a problem that delamination tends to occur accordingly at an interface between an encapsulation resin (cured body), in which electronic parts in particular are encapsulated, and each constituent member.

On the other hand, as a technique to lower the linear expansion coefficient of an encapsulation resin and reduce the occurrence of package warpage, a proposal has been offered in the case of a package of single-sided encapsulation type, such as a ball grid array (BGA), and the proposal consists in warpage reduction by bringing the linear expansion coefficient of such a package close to that of a substrate through a raise in the glass transition temperature of encapsulation resin (see Patent Document 2). Alternatively, study has been made on a method of reducing warpage caused in a package through reduction in linear expansion coefficient of the package by the addition of silicone compounds to encapsulation materials (see Patent Document 3).

Patent Document 1: JP-A-2007-235060
Patent Document 2: JP-A-200r-181479
Patent Document 3: JP-A-8-92352

### SUMMARY OF THE INVENTION

With this being the situation, in the case where packages of single-sided encapsulation type are concerned, warpage occurring in the packages has come to be controlled to some extent through reduction in their linear expansion coefficients. However, in the case where packages of double-cooled structure are concerned, stresses arising from differences in linear expansion coefficients among their individual members resist being released as mentioned above, whereby delamination tends to occur at an interface between an encapsulation resin and each of constituent members. In order to prevent their reliability from deteriorating due to occurrence of the delamination, packages of double-cooled structure are required to have still higher levels of reduction in their linear expansion coefficients.

In view of such circumstances, the invention has been made with an objective of providing an epoxy resin composition for electronic parts encapsulation which ensures excellent low-shrink properties and, in packages of double-cooled structure having high heat-dissipation capabilities and including various types of electronic parts-equipped devices, notably a very exothermic power module, allows prevention of delamination or the like at interfaces inside the packages and achievement of improvement in device reliability, and with a further objective of providing an electronic parts-equipped device using such an epoxy resin composition.

Namely, the present invention relates to the following items 1 to 7.

1. An epoxy resin composition for electronic parts encapsulation, including the following components (A) to (E), in which the component (D) is contained in an amount of from 82 to 88 wt% of the whole of the epoxy resin composition, the component (E) is contained in an amount of from 5 to 15 wt% of the whole of organic components in the epoxy resin composition, and the epoxy resin composition has a gelation time of 15 to 25 seconds:

    (A) an epoxy resin having an ICI viscosity of from 0.008 to 0.1 Pa·s and an epoxy equivalent of from 100 to 200 g/eq;
    (B) a phenol resin having an ICI viscosity of from 0.008 to 0.1 Pa·s and a hydroxyl-group equivalent of from 100 to 200 g/eq;
    (C) a curing accelerator;
    (D) an inorganic filler; and
    (E) a silicone compound.

2. The epoxy resin composition for electronic parts encapsulation according to item 1, in which the silicone compound as the component (E) is a silicone compound represented by the following general formula (1):

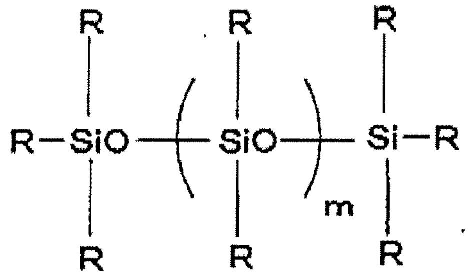

···(1)

in which each R is a monovalent organic group and may be the same as or different from one another, provided that at least two of the Rs in one molecule thereof are organic groups selected from the group consisting of organic groups with amino substituents, organic groups with epoxy substituents, organic groups with hydroxyl substituents, organic groups with vinyl substituents, organic groups with mercpato substituents and organic groups with carboxyl substituents; and m is an integer of 0 to 500.

3. The epoxy resin composition for electronic parts encapsulation according to item 1 or 2, in which the component (A) is a mixture of a triphenylmethane-type epoxy resin and a cresol novolac-type epoxy resin.
4. The epoxy resin composition for electronic parts encapsulation according to any one of items 1 to 3, in which the component (B) is a novolac-type phenol resin.
5. The epoxy resin composition for electronic parts encapsulation according to any one of items 1 to 4, which is an encapsulation material for an electronic module in an electronic parts-equipped device having a double-cooled structure and comprising an electronic module formed by resin-encapsulation of electronic parts and a heat spreader formed on both sides of the electronic module.

6. An electronic parts-equipped device comprising an electronic module which comprises electronic parts encapsulated with the epoxy resin composition for electronic parts encapsulation according to any one of items 1 to 5.
7. The electronic parts-equipped device according to item 6, which has a package form of double-cooled structure in which the electronic module has a heat spreader on both sides thereof.

The present inventors have repeated an extensive study in order to obtain an encapsulation material having excellent low-shrink properties. As a result, we have found that, when preparing an encapsulation material by using an epoxy resin having the ICI viscosity in the above-specified range and the epoxy equivalent in the range specified above [component (A)] and a phenol resin having the ICI viscosity in the above-specified range and hydroxyl-group equivalent in the range specified above [component (B)] in combination with a silicone compound [component (E)], further using an inorganic filler [component (D)] as to have a high filler content falling within the range specified above, moreover adjusting the percentage of the silicone compound [component (E)] to the whole organic components in an epoxy resin composition as the encapsulation material to fall within the range specified above, and besides, designing the epoxy

resin composition to have a short gelation time, we can obtain an epoxy resin composition for electronic parts encapsulation which ensures low-shrink properties, does not cause interface delamination or the like in the interior of packages even in the case of packages of double-cooled structure and can impart high reliability as devices, thereby achieving the invention.

As stated above, an exemplary embodiment of the invention is an epoxy resin composition for electronic parts encapsulation in which an epoxy resin having an ICI viscosity and an epoxy equivalent in the ranges specified respectively [component (A)] and a phenol resin having an ICI viscosity and a hydroxyl-group equivalent in the ranges specified respectively [component (B)] are used in combination with a curing accelerator [component (C)], an inorganic filler [component (D)] and a silicone compound [component (E)], further the inorganic filler [component (D)] is brought to such a high filling state as to have a content falling within the range specified above, and furthermore the silicone compound content (component (E) content) to the whole content of organic components in the epoxy resin composition as an encapsulation material is adjusted to fall within the range specified above. Moreover, the epoxy resin composition is controlled to have a gelation time in the range specified above. Thus, it becomes possible for the encapsulation material to have excellent low-shrink properties, to avoid causing interface delamination or the like in the interior of packages, even a package of double-cooled structure in particular, and to impart high reliability as devices.

When the silicone compound [component (E)] is a silicone compound represented by a specific structural formula, the epoxy resin composition is still more effective in improving the outward appearances of packages and fluidity thereof.

## DETAILED DESCRIPTION OF THE INVENTION

Next we illustrate modes for carrying out the invention.

The present epoxy resin composition for electronic parts encapsulation (hereafter abbreviated as "the epoxy resin composition" in some cases) is a composition obtained by using a specific epoxy resin [component (A)], a specific phenol resin [component (B)], a curing accelerator [component (C)], an inorganic filler [component (D)] and a silicone compound [component (E)], and it is generally in the form of powder or tablet obtained by tableting the powder.

<A: Specific Epoxy Resin>

The specific epoxy resin [component (A)] is an epoxy resin which has an ICI viscosity of from 0.008 to 0.1 Pa·s and has an epoxy equivalent of from 100 to 200 g/eq, especially preferably an epoxy resin which has an ICI viscosity of from 0.02 to 0.1 Pa·s and has an epoxy equivalent of from 150 to 200 g/eq. In other words, when an epoxy resin has too high ICI viscosity, the resultant epoxy resin composition has poor fluidity, thereby suffering degradation in potting capability at package-molding; while an epoxy resin too low in ICI viscosity is hard to obtain, and hence it lacks in practicality. In addition, too high an epoxy equivalent leads to an increase in linear expansion coefficient of a cured body of the resultant epoxy resin composition, and thus the present encapsulation material having low-shrink properties cannot be obtained. And an epoxy resin too low in epoxy equivalent is hard to obtain, and hence it lacks in practicality. Examples of such a specific epoxy resin include a phenol novolac-type epoxy resin, a cresol novolac-type epoxy resin, a triphenylmethane-type epoxy resin and a naphthalenediol aralkyl-type epoxy resin. These resins are used alone or in combination thereof. Of these epoxy resins, those of triphenylmethane and cresol-novolac types are more suitable for use in terms of heat resistance. And especially preferred one is a mixture of triphenylmethane-type and cresol novolac-type epoxy resins.

The specific epoxy resin [component (A)] may be used in combination with various types of epoxy resins other than the specific epoxy resin [component (A)]. In such a case, it is appropriate that the specific epoxy resin [component (A)] constitute at least 70 wt% of all the epoxy resins used together.

The ICI viscosity, incidentally, is measured e.g. as follows. To be specific, a measurement sample is mounted on a hot platen set at 150°C, and a cone for viscosity measurement is lowered until the sample becomes lodged between the cone and the hot platen. And the viscous drag under rotation of the cone is measured, and this measurement value is defined as ICI viscosity. A description of ICI viscometers, incidentally, can be found in e.g. ASTM D4287 (2010).

<B: Specific Phenol Resin>

The specific phenol resin [component (B)] used in combination with the specific epoxy resin [component (A)] is a phenol resin having the function of curing the epoxy resin [component (A)]. And this specific phenol resin is a phenol resin which has an ICI viscosity of from 0.008 to 0.1 Pa·s and has a hydroxyl-group equivalent of from 100 to 200 g/eq, especially preferably a phenol resin which has an ICI viscosity of from 0.05 to 0.08 Pa·s and has a hydroxyl-group equivalent of from 100 to 160 g/eq. In other words, when a phenol resin has too high ICI viscosity, the resultant epoxy resin composition has poor fluidity, thereby suffering degradation in potting capability at package-molding; while a phenol

resin too low in ICI viscosity is hard to obtain, and hence it lacks in practicality. In addition, too high a hydroxyl-group equivalent leads to an increase in linear expansion coefficient of a cured body of the resultant epoxy resin composition, and thus the present encapsulation material having low-shrink properties cannot be obtained. And a phenol resin too low in hydroxyl-group equivalent is hard to obtain, and hence it lacks in practicality. Examples of such a specific phenol resin include a novolac-type phenol resin, a cresol novolac resin, a triphenylmethane-type phenol resin and a phenol aralkyl resin. These resins may be used alone or in combination thereof. And, in point of heat resistance, what are most suitable for use among those phenol resins are a triphenylmethane-type phenol resin and a novolac-type phenol resin, notably a novolac-type phenol resin.

In the invention, the specific phenol resin [component (B)] may be used in combination with various types of phenol resins other than the specific phenol resin [component (B)]. In such a case, it is appropriate that the specific phenol resin [component (B)] constitute at least 70 wt% of all the phenol resins used together.

Additionally, as in the case of the specific epoxy resin [component (A)], ICI viscosity measurement in the case of the specific phenol resin [component (B)] is made e.g. as follows. To be specific, a measurement sample is mounted on a hot platen set at 150°C, and a cone for viscosity measurement is lowered until the sample becomes lodged between the cone and the hot platen. And the viscous drag under rotation of the cone is measured, and this measurement value is defined as ICI viscosity. A description of ICI viscometers, incidentally, can be found in e.g. ASTM D4287 (2010).

As to the mixing proportion between the component (A) and the component (B), it is appropriate in terms of their reactivities to adjust the epoxy equivalent of the component (A) to be from 0.6 to 1.2, preferably from 0.7 to 1.1, with respect to one equivalent of phenolic hydroxyl-group in the component (B).

<C: Curing Accelerator>

Examples of a curing accelerator [component (C)] used in combination with the component (A) and the component (B) include curing accelerators of an amine type, those of an imidazole type, those of an organophosphorus type and those of a phosphorus-boron type. More specifically, they include curing accelerators of an organophosphorus type, such as tetraphenylphosphonium tetraphenyl borate and triphenylphosphine, curing accelerators of an imidazole type, such as 2-phenyl-4-methyl-5-hydroxymethylimidazole and phenylimidazole, and curing accelerators of a tertiary amine type, such as 1,8-diazabicyclo[3.4.0]undecene-7 and 1,5-diazabicyclo[4.3.0]nonene-5. These curing accelerators may be used alone, or at least any two of them may be used in combination. Among them, curing accelerators of an imidazole type and those of an organophosphorus type are more suitable for use than the others in terms of general versatility in the market and costs.

As to the content of curing accelerator (component (C)), it is preferable in the case of curing accelerators of e.g. an imidazole type that the content thereof is adjusted to fall within the range of 5 wt% to 15wt%, preferably 7 to 13 wt%, based on the total content of the specific phenol resins [component (B)]. In other words, it is because, when the content of the curing accelerator is too low, the resultant epoxy resin composition tends to aggravate its curability; while, when the content of the curing accelerator is too high, the resultant epoxy resin composition causes reduction in fluidity and tends to aggravate its potting capability at package-molding.

<D: Inorganic Filler>

Examples of an inorganic filler [component (D)] used in combination with the components (A) to (C) include silica glass, talc and various kinds of powder, such as, silica powder (fused silica powder, crystalline silica powder, etc.), alumina powder, aluminum nitride powder and silicon nitride powder. Those inorganic fillers can be used in any form, such as a crushed form, a spherical form or a ground form. Those inorganic fillers are used alone or as mixtures of two or more thereof. Of these inorganic fillers, silica powder is more suitable for use than the others from the viewpoint of allowing reduction in thermal linear expansion coefficient of a cured body of the epoxy resin composition obtained, thereby allowing control of internal stresses, and consequently, allowing prevention of warpage of a substrate after encapsulation. As to the silica powder, fused silica powder is especially preferred in terms of high filling capability and high flowability. The fused silica powder includes a fused spherical silica powder and fused crushed silica powder, and in view of flowability, the use of the fused spherical silica powder is preferable.

In addition, it is appropriate that the inorganic filler [component (D)] have an average particle size in a range of 1 μm to 30 μm, especially preferably in a range of 2 μm to 20 μm. The average particle diameter of the inorganic filler (component (D)) can be determined by, for example, selecting a random measurement sample from a population and measuring a particle diameter thereof using the commercially available laser diffraction/scattering particle size distribution analyzer.

In addition, it is required that the content of the inorganic filler (component (D)) is adjusted to 82 wt% to 88 wt%, especially preferably 84 wt% to 86 wt%, of the whole of the epoxy resin composition. In other words, it is because, when the content of the inorganic filler (component (D)) is too low, the linear expansion coefficient of a cured body of the

resultant epoxy resin composition becomes high, whereby such a characteristic effect as reduction in shrinkage cannot be attained; while, when the content of the inorganic filler (component (D)) is too high, the resultant epoxy resin composition is reduced in fluidity, whereby potting capability at package-molding is degraded.

<E: Silicone Compound>

As the silicone compound [component (E)] used in combination with the components (A) to (D), any of silicone compounds represented by the following general formula (1) is suitable for use in terms of appearance of the package and fluidity of a resultant epoxy resin composition.

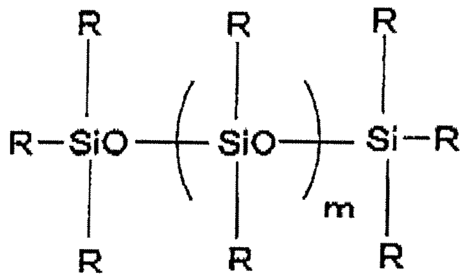

···(1)

In the formula (1), each R is a monovalent organic group and may be the same as or different from one another, provided that at least two of the Rs in one molecule thereof are organic groups selected from the group consisting of organic groups with amino substituents, organic groups with epoxy substituents, organic groups with hydroxyl substituents, organic groups with vinyl substituents, organic groups with mercpato substituents and organic groups with carboxyl substituents. And m is an integer of 0 to 500.

Silicone compounds represented by the formula (1) in which all the Rs are organic groups with epoxy substituents are preferable.

Examples of products commercially available as such silicone compounds include SF8421EG manufactured by Dow Corning Toray Co., Ltd. (epoxy equivalent: 9,000; viscosity: 3,000 $mm^2/s$), FZ-3730 manufactured by Dow Corning Toray Co., Ltd. (epoxy equivalent: 5,000; viscosity: 2,500 $mm^2/s$), BY16-869 manufactured by Dow Corning Toray Co., Ltd. (epoxy equivalent: 7,000; viscosity: 800 $mm^2/s$), BY16-870 manufactured by Dow Corning Toray Co., Ltd. (epoxy equivalent: 1,500; viscosity: 600 $mm^2/s$), X-22-4741 manufactured by Shin-Etsu Chemical Co., Ltd. (epoxy equivalent: 2,500; viscosity: 350 $mm^2/s$), KP-1002 manufactured by Shin-Etsu Chemical Co., Ltd. (epoxy equivalent: 4,300; viscosity: 4,500 $mm^2/s$) and X-22-343 manufactured by Shin-Etsu Chemical Co., Ltd. (epoxy equivalent: 500 to 550; viscosity: 25 $mm^2/s$). As the silicone compounds as mentioned above, compounds capable of being purchased as manufactured products or reagents may be used, or it is all right to use compounds synthesized by conventionally-known methods.

The content of the silicone compound (component (E)) is required to be from 5 to 15 wt%, especially preferably from 8 to 12 wt%, of the whole of organic components in the epoxy resin composition. In other words, this is because too low the content of the silicone compound (component (E)) leads to an increase in linear expansion coefficient of a cured body of the resultant epoxy resin composition, while too high the content of a silicon compound leads to a reduction in strength of a cured body of the resultant epoxy resin composition.

<Additives of Various Kinds>

Besides containing the components (A) to (E), the present epoxy resin composition can contain various kinds of additives, if necessary, in such amounts as not to impair functions of the epoxy resin composition. Examples of such additives include an adhesiveness imparting agent, a conductivity imparting agent for an antistatic measure, a flame retardant, an ion trapping agent, an antioxidant, a stress reducing agent, a release agent, a fluidity imparting agent, a moisture absorbent and a pigment.

As to the release agent, examples thereof include compounds such as a higher aliphatic acid, a higher aliphatic ester and a calcium salt of higher aliphatic acid, and more specifically, carnauba wax, oxidized polyethylene wax or so on can be used. These compounds may be used alone in combination thereof.

Examples of the flame retardant include organophosphorus compounds, antimony oxide and metal hydroxides, such as aluminum hydroxide and magnesium hydroxide. These compounds may be used alone in combination thereof.

As the pigment, carbon black having the effect of removing static electricity or the like can be used.

In addition to the additives various in kind, various types of coupling agents, including γ-mercaptopropyltrimethoxysilane and so on, can be used as appropriate.

<Preparation of Epoxy Resin Composition>

The epoxy resin composition for semiconductor encapsulation according to the present invention can be produced, for example, as follows. The components (A) to (E) and if necessary, one or more other additives are appropriately blended, and the resulting mixture is melt-kneaded under heating in a kneader such as a mixing roll. The kneaded mixture is cooled to room temperature to obtain a solid. The solid is pulverized by the conventional means. If necessary, the powder is compressed into tablets. Thus, the intended epoxy resin composition can be produced by a series of the steps.

The epoxy resin composition thus obtained is required to have a gelation time of 15 to 25 seconds. In other words, this is because, when its gelation time is too long, the epoxy resin composition brings about an increase in linear expansion coefficient, and results in occurrence of significant warpage; while, when its gelation time is too short, the epoxy resin composition suffers degradation in potting capability at the time of encapsulation. By thus specifying the range of a gelation time, which is one of the physical properties, of the epoxy resin composition obtained, it becomes possible to well control the occurrence of warpage and to impart satisfactory potting capability. Examples of a method for adjusting the gelation time of the epoxy resin composition include the method of controlling the compounding ratio of a curing accelerator [component (C)] to the total for the specific phenol resins [component (B)] added and the method of controlling kneading conditions.

By the way, the gelation time is determined e.g. as follows. About 0.1 to 0.5 g of each epoxy resin composition obtained in the Examples and Comparative Examples was placed on a 175°C hot flat plate, and was stirred with a glass bar having a diameter of 1.5 mm. Time until resin cobwebbing has not been observed was taken as gelation time (second).

<Electronic parts-equipped device>

A cured material obtained from the present epoxy resin composition through curing reaction is outstanding for its heat resistance, and hence it is quite suitable for application to electronic materials, such as a laminate for a printed wiring board, a printed wiring board and a semiconductor-equipped module, in addition to use as a material for encapsulating various kinds of electronic parts including semiconductors. And the method of encapsulating electronic parts with the epoxy resin composition obtained in the foregoing manner has no particular restrictions, and encapsulation of electronic parts with resin can be performed in accordance with a conventionally-known molding method such as usual transfer molding.

As one example of an electronic parts-equipped device comprising the epoxy resin composition according to the present invention, a package of double-cooled structure in which an electronic module formed by resin encapsulation of electronic parts has a heat spreader on both sides thereof More specifically, such a package is an electronic parts-equipped device in which an electronic module having in its insides electronic parts such as a semiconductor element has on both sides thereof a pair of insulating members placed so that the electronic module is sandwiched between the insulating members and further has a pair of cooling members on the periphery of each of the insulating members so that the pair of insulating members are sandwiched between the cooling members. And the epoxy resin composition of the present invention is useful as a forming material (encapsulation material) for the resin-encapsulated portion (cured body) of the electronic module formed by resin encapsulation of electronic parts.

EXAMPLES

The present invention is described below by reference to the following Examples and Comparative Examples, but the invention is not construed as being limited to those Examples.

In advance of preparation of an epoxy resin composition, the following components were prepared.

[Epoxy resin al]

Triphenylmethane-type epoxy resin (epoxy equivalent: 170 g/eq; ICI viscosity: 0.1 Pa·s; EPPN-501HY manufactured by NIPPON KAYAKU Co., Ltd.,)

[Epoxy resin a2]

o-Cresol novolac-type epoxy resin (epoxy equivalent: 198 g/eq; ICI viscosity: 0.02 Pa·s; EOCN-1020 manufactured by NIPPON KAYAKU Co., Ltd.,)

[Epoxy resin a3]

Biphenyl aralkyl-type epoxy resin (epoxy equivalent: 284 g/eq; ICI viscosity: 0.07 Pa·s; NC-3000 manufactured by NIPPON KAYAKU Co., Ltd.,)

[Phenol resin b1]

Novolac-type phenol resin (hydroxyl-group equivalent: 105 g/eq; ICI viscosity: 0.06 Pa·s; H-4 manufactured by MEIWA PLASTIC INDUSTRIES, LTD.,)

[Phenol resin b2]

Phenol biphenylene-type phenol resin (hydroxyl-group equivalent: 210 g/eq; ICI viscosity: 0.26 Pa·s; MEH-785IM manufactured by MEIWA PLASTIC INDUSTRIES, LTD.,)

[Inorganic filler]

Spherical fused silica powder (average particle size: 20 μm)

[Curing accelerator]

2-Phenyl-4-methyl-5-hydroxymethylimidazole (2P4MHZ manufactured by SHIKOKU CHEMICALS CORPORATION,)

[Release agent]

Oxidized polyethylene wax (acid value: 17; PED521 manufactured by Clariant,)

[Silane coupling agent]

γ-Mercaptopropyltrimethoxysilane (KBM-803 manufactured by Shin-Etsu Chemical Co., Ltd.,)

[Silicone compound]

Alkylene group-containing organopolysiloxane (epoxy equivalent: 9,000 g/eq; viscosity: 3,000 $mm^2/s$; SF8421EG manufactured by Dow Corning Toray Co., Ltd.,)

[Flame retardant]

Aluminum hydroxide (HP-360 manufactured by a product of Showa Denko K.K.,)

[Ion trapping agent]

Zirconium compound (IXE-100 manufactured by TOAGOSEI CO., LTD.,)

[Pigment]

Carbon black (#3030B manufactured by Mitsubishi Chemical Corporation,)

[EXAMPLES 1 to 6 and COMPARATIVE EXAMPLES 1 to 9]

Various kinds of ingredients listed in each of the following Tables 1 and 2 were mixed together at room temperature in their respective proportions as shown in those tables and, by being put through a roll kneader heated to temperatures ranging from 80°C to 120°C, they were fused and kneaded over a 5-minute period. In this way, a fused mixture was obtained. After cooling this fused mixture, the solidified substance thus obtained was ground into powder, whereby an intended epoxy resin composition was prepared.

On each of the thus obtained epoxy resin compositions as Examples and Comparative Examples, measurements and evaluations of its characteristics were made in accordance with the following methods. Results obtained are

also shown in the following Tables 1 and 2.

[Linear expansivity]

From each of the epoxy resin compositions obtained, a cured material as a test piece (measuring 80 mm in diameter and 8 mm in thickness) was made by transfer molding (for 2 minutes at 175°C). The molding shrinkage (X) was determined from the test piece by the use of a micrometer (a coolant-proof micrometer manufactured by Mitutoyo Corporation), and the linear expansivity (Y) under a condition of cooling the test piece to room temperature (25°C) after the molding was determined in accordance with the following equation.

$$Y = X / (\text{molding temperature} - \text{temperature at which molding shrinkage is measured})$$

The thus determined linear expansivity (Y) of each cured material in a period between the completion of cooling to room temperature and the completion of molding was evaluated on the following criteria.
Pass: Being lower than 25.0 ppm/K in linear expansivity.
Fail: Being 25.0 ppm/K or higher in linear expansivity.

[Gelation time]

About 0.5 g of each epoxy resin composition obtained was placed on a 175°C hot flat plate, and was stirred with a glass bar having a diameter of 1.5 mm. Time until resin cobwebbing has not been observed was taken as gelation time (second), and the time lapsed until such gelation occurred was measured. The measurement result of the gelation time thus obtained was evaluated on the following criteria.
Pass: Being from 15 to 25 sec in gelation time.
Fail: Being out of the above-specified range in gelation time.

[Spiral flow]

A spiral flow (SF) value (cm) was measured using a mold for spiral flow measurement under conditions of 175+5°C, 120 seconds and 70 $kg/cm^2$ in conformance with the method of EMM 1-66. In accordance with this measurement result, each composition was evaluated on the following criteria.
Pass: Being 50 cm or higher in SF value.
Fail: Being lower than 50 cm in SF value.

[Bending strength]

From each of the epoxy resin compositions obtained in the foregoing manner, a cured material was made by means of transfer molding (at 175°C for 2 minutes) (in conformance with JIS K6911 (2006)). And bending strength measurement was performed on the cured material by means of an AutoGraph (a bending test system AG-500, manufactured by Shimadzu Corporation). In accordance with this measurement result, each cured material was evaluated on the following criteria.
Pass: Being 100 MPa or higher in bending strength.
Fail: Being lower than 100 MPa in bending strength.
Table 1

| (parts by weight) |
| --- |

(continued)

| | | Example | | | | | |
|---|---|---|---|---|---|---|---|
| | | 1 | 2 | 3 | 4 | 5 | 6 |
| Epoxy resin (A) | a1 | 53.1 | 47.3 | 38.5 | 34.5 | 30.8 | 38.7 |
| | a2 | 53.1 | 47.3 | 38.5 | 34.5 | 30.8 | 38.7 |
| | a3 | - | - | - | - | - | - |
| Phenol resin (B) | b1 | 48.5 | 43.3 | 35.2 | 31.5 | 28.1 | 35.4 |
| | b2 | - | - | - | - | - | - |
| Curing accelerator (C) | | 3.9 | 3.5 | 2.8 | 2.5 | 2.2 | 2.1 |
| Silicone compound (E) | | 8.6 | 25.8 | 13.2 | 5.8 | 16.8 | 13.2 |
| Inorganic filler (D) | | 715.0 | 716.0 | 780.2 | 812.4 | 812.4 | 780.2 |
| Flame retardant | | 103.2 | 103.2 | 79.1 | 67.1 | 67.1 | 79.1 |
| Ion trapping agent | | 0.9 | 0.9 | 0.7 | 0.6 | 0.6 | 0.7 |
| Release agent | | 4.3 | 4.3 | 3.3 | 2.8 | 2.8 | 3.3 |
| Pigment | | 6.0 | 6.0 | 6.0 | 6.0 | 6.0 | 6.0 |
| Silane coupling agent | | 2.6 | 2.6 | 2.5 | 2.5 | 2.5 | 2.5 |
| Inorganic filler content (wt%)*1 | | 82 | 82 | 86 | 88 | 88 | 86 |
| Silicone compound content (wt%)*2 | | 5 | 15 | 10 | 5 | 15 | 10 |
| Linear expansivity (ppm/K) | | Pass 24.7 | Pass 22.0 | Pass 18.6 | Pass 16.0 | Pass 14.0 | Pass 21.5 |
| Gelation time (sec) | | Pass 20 | Pass 20 | Pass 20 | Pass 20 | Pass 20 | Pass 25 |
| Spiral flow (cm) | | Pass 110 | Pass 120 | Pass 75 | Pass 50 | Pass 60 | Pass 80 |
| Bending strength (MPa) | | Pass 130 | Pass 100 | Pass 115 | Pass 130 | Pass 100 | Pass 115 |

*1: percentage (% by weight) to the whole of the epoxy resin composition
*2: percentage (% by weight) to the whole of organic components in the epoxy resin composition

Table 2 (parts by weight)

| | | Comparative Example | | | | | | | | |
|---|---|---|---|---|---|---|---|---|---|---|
| | | 1 | 2 | 3 | 4 | 5 | 6 | 7 | 8 | 9 |
| Epoxy resin (A) | a1 | 56.2 | 55.9 | 44.4 | 39.0 | 36.4 | 28.9 | 31.4 | - | 39.5 |
| | a2 | 56.2 | 55.9 | 44.4 | 39.0 | 36.4 | 28.9 | 31.4 | - | 39.5 |
| | a3 | - | - | - | - | - | - | - | 119.4 | - |
| Phenol resin (B) | b1 | 51.3 | 51.1 | 40.6 | 35.6 | 33.3 | 26.4 | 29.7 | 35.3 | - |
| | b2 | - | - | - | - | - | - | - | - | 72.3 |
| Curing accelerator (C) | | 4.1 | 4.1 | 3.2 | 1.4 | 2.7 | 2.1 | 2.3 | 3.9 | 7.2 |
| Silicone compound (E) | | 9.1 | 0.0 | 34.4 | 13.2 | 0.0 | 22.4 | 5.1 | 8.6 | 8.6 |
| Inorganic filler (D) | | 699.9 | 716.0 | 716.0 | 780.2 | 812.4 | 812.4 | 828.4 | 716.0 | 716.0 |
| Flame retardant | | 109.2 | 103.2 | 103.2 | 79.1 | 67.1 | 67.1 | 61.1 | 103.2 | 103.2 |
| Ion trapping agent | | 0.9 | 0.9 | 0.9 | 0.7 | 0.6 | 0.6 | 0.5 | 0.9 | 0.9 |
| Release agent | | 4.5 | 4.3 | 4.3 | 3.3 | 2.8 | 2.8 | 2.5 | 4.3 | 4.3 |
| Pigment | | 6.0 | 6.0 | 6.0 | 6.0 | 6.0 | 6.0 | 6.0 | 6.0 | 6.0 |
| Silane combing agent | | 2.6 | 2.6 | 2.6 | 2.5 | 2.5 | 2.5 | 2.5 | 2.6 | 2.6 |
| Inorganic filler content (wt%)*1 | | 81 | 82 | 82 | 86 | 88 | 88 | 89 | 82 | 82 |
| Silicone compound content (wt%)*2 | | 5 | 0 | 20 | 10 | 0 | 20 | 5 | 5 | 5 |
| Linear expansivity (ppm/K) | | Fail 26.0 | Fail 26.0 | Pass 20.7 | Fail 25.5 | Pass 18.0 | Pass 12.7 | Pass 15.3 | Fail 27.5 | Fail 27.0 |
| Gelation time (sec) | | Pass 20 | Pass 20 | Pass 20 | Fail 30 | Pass 20 | Pass 20 | Pass 20 | Pass 20 | Pass 20 |
| Spiral flow (cm) | | Pass 120 | Pass 105 | Pass 125 | Pass 85 | Fail 45 | Pass 65 | Fail 40 | Pass 105 | Fail 45 |

(continued)

| | Comparative Example | | | | | | | | |
|---|---|---|---|---|---|---|---|---|---|
| | 1 | 2 | 3 | 4 | 5 | 6 | 7 | 8 | 9 |
| Bending strength (MPa) | Pass 130 | Pass 145 | Fail 85 | Pass 115 | Pass 145 | Fail 85 | Pass 130 | Pass 130 | Pass 130 |
| *1: percentage (% by weight) to the whole of the epoxy resin composition<br>*2: percentage (% by weight) to the whole of organic components in the epoxy resin composition | | | | | | | | | |

As can be seen from the results shown above, all the articles according to Examples ensured a low linear expansivity less than 25.0 ppm/K, and had success in reducing their linear expansion coefficients. Further, it is evident that their gelation times are in a proper range, their spiral flow values are 50 cm or greater, or equivalently, they show good fluidity, and they ensure high measured values of bending strength, or excellence in strength.

On the other hand, the article according to Comparative Example 1 in which the inorganic filler was mixed in such a small amount that the inorganic filler content was below the specified range and the article according to Comparative Example 2 in which no silicone compound was mixed had a linear expansivity of 25.0 ppm/K or above, and therefore, no reduction in linear expansion coefficient can be recognized. In addition, the articles according to Comparative Examples 3 and 6 in which each the silicone compound was mixed in such a large amount that the silicone compound content was beyond the specified range had inferior bending strength. And the article according to Comparative Example 4 which had a long gelation time beyond the specified range can be said as a matter of course to be an encapsulation material having a problem with curability. Further, the article according to Comparative Example 5 in which no silicone compound was mixed and the article according to Comparative Example 7 in which the inorganic filler was mixed in such a large amount that the inorganic filler content was beyond the specified range were short in spiral flow value, or equivalently, they were inferior in fluidity. And the article according to Comparative Example 8 in which the epoxy resin having an epoxy equivalent outside and beyond the specified range was used had a linear expansivity of 25.0 ppm/K or above, and therefore, no reduction in linear expansion coefficient can be recognized.

In addition, the article according to Comparative Example 9 in which the phenol resin having the ICI viscosity outside and beyond the specified range and having the hydroxyl-group equivalent outside and beyond the specified range was used cannot be recognized that it provided reduction in linear expansion coefficient, and was short in spiral flow value and hence inferior in fluidity.

While the invention has been described in detail with reference to specific embodiments thereof, it will be apparent to one skilled in the art that various changes and modifications can be made therein without departing from the spirit and scope thereof.

Incidentally, the present application is based on Japanese Patent Application No. 2011-268039 filed on December 7, 2011, and the contents are incorporated herein by reference.

All references cited herein are incorporated by reference herein in their entirety.

The epoxy resin compositions for electronic parts encapsulation of the invention are useful as encapsulation materials for power devices using large currents, such as insulated-gate bipolar transistors (IGBT) or metal oxide semiconductor field effect transistors (MOSFET).

## Claims

**1.** An epoxy resin composition for electronic parts encapsulation, comprising the following components (A) to (E), wherein the component (D) is contained in an amount of from 82 to 88 wt% of the whole of the epoxy resin composition, the component (E) is contained in an amount of from 5 to 15 wt% of the whole of organic components in the epoxy resin composition, and
the epoxy resin composition has a gelation time of 15 to 25 seconds:

(A) an epoxy resin having an ICI viscosity of from 0.008 to 0.1 Pa·s and an epoxy equivalent of from 100 to 200 g/eq;
(B) a phenol resin having an ICI viscosity of from 0.008 to 0.1 Pa·s and a hydroxyl-group equivalent of from 100 to 200 g/eq;
(C) a curing accelerator;
(D) an inorganic filler; and
(E) a silicone compound.

**2.** The epoxy resin composition for electronic parts encapsulation according to claim 1, wherein the silicone compound as the component (E) is a silicone compound represented by the following general formula (1):

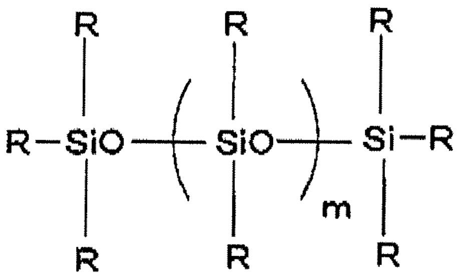

···(1)

in which each R is a monovalent organic group and may be the same as or different from one another, provided that at least two of the Rs in one molecule thereof are organic groups selected from the group consisting of organic groups with amino substituents, organic groups with epoxy substituents, organic groups with hydroxyl substituents, organic groups with vinyl substituents, organic groups with mercpato substituents and organic groups with carboxyl substituents; and m is an integer of 0 to 500.

3. The epoxy resin composition for electronic parts encapsulation according to claim 1 or 2, wherein the component (A) is a mixture of a triphenylmethane-type epoxy resin and a cresol novolac-type epoxy resin.

4. The epoxy resin composition for electronic parts encapsulation according to any one of claims 1 to 3, wherein the component (B) is a novolac-type phenol resin.

5. The epoxy resin composition for electronic parts encapsulation according to any one of claims 1 to 4, which is an encapsulation material for an electronic module in an electronic parts-equipped device having a double-cooled structure and comprising an electronic module formed by resin-encapsulation of electronic parts and a heat spreader formed on both sides of the electronic module.

6. An electronic parts-equipped device comprising an electronic module which comprises electronic parts encapsulated with the epoxy resin composition for electronic parts encapsulation according to any one of claims 1 to 5.

7. The electronic parts-equipped device according to claim 6, which has a package form of double-cooled structure in which the electronic module has a heat spreader on both sides thereof.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007235060 A
- JP 200R181479 A
- JP 8092352 A
- JP 2011268039 A